# EUROPÄISCHE PATENTSCHRIFT

(11) **EP 2 037 578 B1**
(45) Veröffentlichungstag und Bekanntmachung des Hinweises auf die Patenterteilung: **11.02.2015**
(21) Anmeldenummer: 08105093.2
(22) Anmeldetag: 21.08.2008
(51) Int. Cl.: H03J 1/00, H03J 1/04

(54) **Rundfunkempfänger und Verfahren zum Betreiben eines Rundfunkempfängers**
Radio receiver and method for operating same
Récepteur radio et procédé de fonctionnement d'un récepteur radio

(30) Priorität: 24.08.2007 DE 102007040285
(43) Veröffentlichungstag der Anmeldung: 18.03.2009
(73) Patentinhaber: Continental Automotive GmbH, 30165 Hannover (DE)
(72) Erfinder: Klein, Bernhard, 93186 Pettendorf (DE); Ruehl, Hans-Wilhelm, 35606 Solms (DE); Wilkening, Sten-Olaf, 61381 Friedrichsdorf (DE)

(56) Entgegenhaltungen:
- EP-A1- 0 772 120
- DE-A1- 19 529 075
- DE-A1- 19 719 912
- DE-A1- 19 838 039
- JP-A- 9 247 008
- JP-A- 2006 229 748

## Beschreibung

Die Erfindung betrifft einen Rundfunkempfänger mit einem Rundfunkempfangsteil und einem Decoder für über eine Rundfunkfrequenz empfangene Daten, die eine Kennung enthalten. Weiterhin betrifft die Erfindung ein Verfahren zum Betreiben eines Rundfunkempfängers, der zum Empfang von Daten, die eine Kennung enthalten, über eine Rundfunkfrequenz ausgelegt ist.

Ein derartiger Rundfunkempfänger und ein derartiges Rundfunkempfangsverfahren sind beispielsweise aus der DE 197 19 912 A1 bekannt. Dieser bekannte Empfänger weist einen Datendecoder zum Decodieren von RDS (Radio Data System) Datensignalen auf, die zusammen mit einem empfangenen Rundfunksignal übertragen worden sind.

Bestandteil der übertragenen und empfangenen RDS Daten ist der sogenannte PI (Programm Identifyer) Code. Anhand des empfangenen PI-Codes wird das Rundfunkprogramm, beispielsweise "HR 1" identifiziert und der entsprechende Programmname kann auf dem Display ausgegeben werden.

Nachteilig ist hierbei, dass die auf dem Display angezeigte Information zu dem empfangenen oder den empfangbaren Programmen als eine Folge von alphanumerischen Zeichen angezeigt wird, die gerade bei einem Einsatz im Kraftfahrzeug mitunter nicht schnell erfassbar bzw. unterscheidbar ist und daher unnötig vom Verkehrsgeschehen ablenkt.

Aufgabe der Erfindung ist es, einen Rundfunkempfänger bzw. ein Verfahren zum Betreiben eines Rundfunkempfängers anzugeben, mit dem ein empfangenes bzw. ein empfangbares Rundfunkprogramm schneller optisch erfassbar ist und somit die Bedienung des Rundfunkempfängers erleichtert wird.

Die Aufgabe wird gelöst durch einen Rundfunkempfänger mit
- einem Rundfunkempfangsteil,
- einem Decoder für über eine Rundfunkfrequenz empfangene Daten, die eine Kennung enthalten,
- mindestens einem Speicherelement,
- einer Vielzahl von abgespeicherten Kennungen, die in dem mindestens einen Speicherelement abgelegt sind,
- graphischen Elementen, die in dem mindestens einem Speicherelement abgelegt sind, wobei zumindest einigen der abgespeicherten Kennungen jeweils eines der graphischen Elemente zugeordnet ist,
- einem graphikfähigen Display,
- Mitteln zum Extrahieren der Kennung aus den empfangenen Daten und zum Vergleich der extrahierten Kennung mit der Vielzahl von in dem Speicherelement abgespeicherten Kennungen und zur Auswahl des einer abgespeicherten Kennung, die mit der extrahierten Kennung übereinstimmt, zugeordneten graphischen Elements und
- Mitteln zur Darstellung des ausgewählten graphischen Elements auf dem graphikfähigen Display.

Weiterhin wird die Aufgabe gelöst durch ein Verfahren zum Betreiben eines Rundfunkempfängers mit den Schritten:
- Empfang von Daten, die eine Kennung enthalten, über eine Rundfunkfrequenz,
- Extrahieren der Kennung aus den empfangenen Daten,
- Vergleichen der extrahierten Kennung mit einer Vielzahl von in einem Speicherelement abgespeicherten Kennungen,
- Auswahl eines einer abgespeicherten Kennung, die mit der extrahierten Kennung übereinstimmt, zugeordneten graphischen Elements, das in einem Speicherelement abgespeichert ist,
- Darstellen des ausgewählten graphischen Elements auf einem graphikfähigen Display.

Der Rundfunkempfänger bzw. das Verfahren ist somit zunächst zum Empfang von Daten, die eine Kennung enthalten, ausgelegt. Die mit den Daten empfangene Kennung wird aus diesen extrahiert und decodiert (oder umgekehrt). In einem Speicherelement des Rundfunkempfängers ist eine Vielzahl von Kennungen abgespeichert. Weiterhin sind in einem Speicherelement auch graphische Elemente abgespeichert, wobei weiterhin eine Zuordnung zwischen den abgespeicherten Kennungen und den graphischen Elementen gegeben ist. Die aus den empfangenen Daten extrahierte Kennung wird nun mit den abgespeicherten Kennungen verglichen und bei Übereinstimmung der empfangenen Kennung mit einer der abgespeicherten Kennungen wird das dieser abgespeicherten Kennung zugeordnete graphische Element ausgewählt und auf dem graphikfähigen Display angezeigt. Somit ist es möglich, anstelle einer bekannten alphanumerischen Anzeige der Kennung ein zugehöriges graphisches Element anzuzeigen. Graphische Elemente können von einem Benutzer in der Regel schneller erfasst und unterschieden werden als alphanumerische Zeichenfolgen. Somit kann der Benutzer insbesondere bei Anwendung im Kraftfahrzeug die wiedergegebene Information schneller erfassen und wird weniger vom Verkehrsgeschehen abgelenkt.

Wird zusätzlich zu dem graphischen Element auf dem graphikfähigem Display auch noch eine alphanumerische Anzeige der Kennung wiedergegeben, so kann die schnelle und sichere Erkennbarkeit bzw. Unterscheidbarkeit verschiedener Kennungen weiter erhöht werden.

Handelt es sich bei dem Rundfunkempfänger um einen Rundfunkempfänger zum Empfang von analogen Rundfunksendungen, so kann es sich bei den Daten insbesondere um Daten des Radiodatensystems (RDS) handeln. Somit kann auch durch eine relativ einfache Modifikation von bekannten RDS-Rundfunkempfängern eine graphische Anzeige einer Kennung erfolgen. Dies ist insbesondere deshalb von Bedeutung, da es sich bei RDS um ein etabliertes System handelt.

Handelt es sich bei dem Rundfunkempfänger um einen Rundfunkempfänger zum Empfang von digitalen Rundfunksendungen, so können die Vorteile der Erfindung auch bei digitalen Rundfunkempfängern genutzt werden.

Handelt es sich bei den extrahierten Daten um Kenndaten eines Rundfunkprogramms und bei dem graphischen Element um eine Programmkennung, insbesondere ein Senderlogo, so kann die Programmauswahl besonders einfach gestaltet werden, da ein graphisches Element durch den Benutzer sehr gut erfassbar und von anderen graphischen Elementen unterscheidbar ist.

Werden auf dem graphikfähigen Display Senderlogos mehrerer empfangbarer Rundfunkprogramme dargestellt, so kann auf besonders einfache Weise durch Auswahl eines dargestellten Senderlogos das gewünschte Rundfunkprogramm gewählt werden.

Zu den von den Rundfunkempfängern ausgestrahlten Zusatzdaten gehören bereits heute auch Informationen zu einem aktuell gespielten Liedtitel. Handelt es sich daher bei dem graphischen Element um eine Kennung eines Liedtitels oder eines Liederalbums, das insbesondere zusätzlich zu einer Textanzeige auf dem graphikfähigen Display angezeigt wird, so kann auch hierdurch eine gefällige und durch den Benutzer leicht erfassbare Anzeige erreicht werden.

Weist der Rundfunkempfänger eine Schnittstelle zum Übertragen eines graphischen Elements in das Speicherelement des Rundfunkempfängers auf, so können die im Rundfunkempfängers abgespeicherten graphischen Elemente stets aktualisiert und ergänzt werden. Bei der Schnittstelle kann es sich um eine drahtgebundene oder eine drahtlose Schnittstelle, wie beispielsweise eine Kurzstreckenfunkverbindung nach dem sogenannten Bluetooth-Verfahren handeln. Insbesondere kann die Schnittstelle zum Verbinden des Rundfunkempfängers mit einem mobilen Datenträger und zur Übertragung eines graphischen Elements von dem mobilen Datenträger zu dem Rundfunkempfänger ausgebildet sein. Bei dem mobilen Datenträger kann es sich beispielsweise um eine Speicherkarte handeln, die in einen im Radiogerät vorhandenen Kartenleser eingeführt wird. Andere Ausgestaltungen, beispielsweise in Form eines mobilen Datenträgers, der über eine USB-Schnittstelle mit dem Autoradio verbunden wird, sind ebenfalls möglich.

Der Rundfunkempfänger kann als eigenständiges Autoradio ausgebildet sein, das beispielsweise für den Nachrüsteinbau in einen genormten Schacht im Kraftfahrzeug ausgebildet ist. Der Rundfunkempfänger kann jedoch auch Bestandteil eines Multimediasystems, insbesondere eines Kraftfahrzeugmultimediasystems sein. Einzelne Komponenten des Rundfunkempfängers, wie beispielsweise das Speicherelement oder das Display können dabei gemeinsame Elemente des Multimediasystems sein und von anderen Komponenten des Multimediasystems mit genutzt werden. Insbesondere können bei einer derartigen Ausgestaltung als Multimediasystem auf dem graphikfähigen Display weitere graphischen Elemente zur Kennzeichnung weiteren im Multimediasystem zur Verfügung stehender Liedtitel oder Liedalben anzeigbar sein bzw. angezeigt werden.

Die Erfindung wird nachfolgend anhand eines Ausführungsbeispiels und der Zeichnung näher erläutert. Es zeigen:
- Fig. 1:: ein einfaches Blockschaltbild eines Rundfunkempfängers,
- Fig. 2:: ein Blockschaltbild eines Multimediasystems,
- Fig. 3:: ein Ablaufdiagramm,
- Fig. 4:: eine erste Displayanzeige,
- Fig. 5:: eine zweite Displayanzeige.

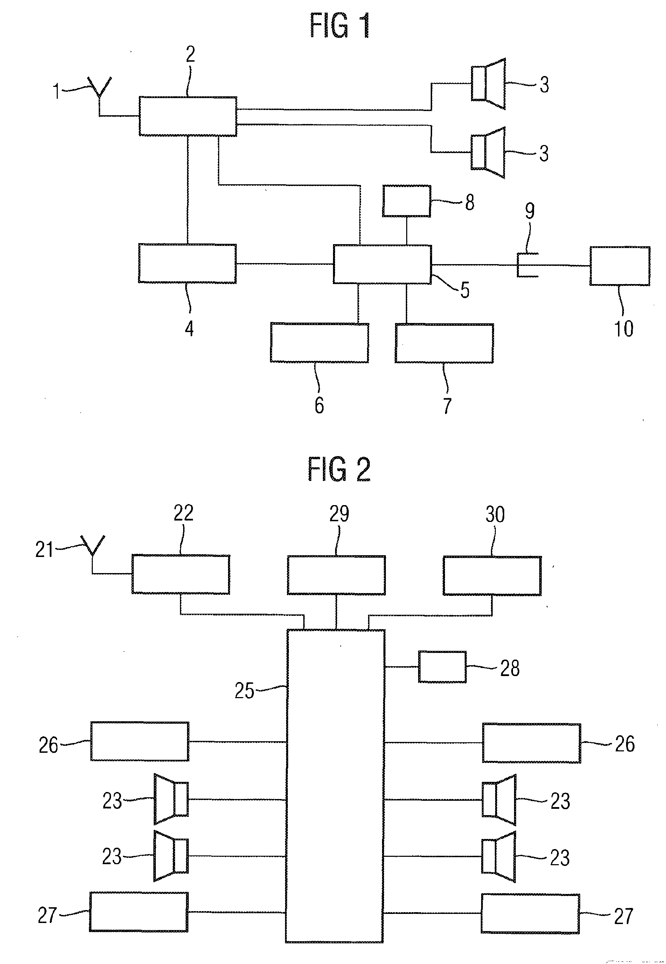

Fig. 1 zeigt ein schematisches Blockschaltbild eines erfindungsgemäßen Rundfunkempfängers. Über eine Antenne 1 gelangen Rundfunksignale an ein Rundfunkempfangsteil 2. Das Rundfunkempfangsteil 2 enthält mehrere Komponenten. In dem Rundfunkempfangsteil 2 werden die empfangenen Rundfunksignale zunächst in üblicher Weise demoduliert. Die daraus gewonnenen, niederfrequenten Tonsignale werden einem Tonsignalverstärker zugeführt, darin verstärkt und zur Wiedergabe mindestens einem Lautsprecher 3 zugeführt.

Das Rundfunkempfangsteil 2 kann ein oder mehrere Empfangsstufen enthalten. Enthält das Rundfunkempfangsteil 2 mindestens zwei Empfangsstufen, so kann eine der Empfangsstufen dazu genutzt werden, ein Frequenzband abzuscannen und die empfangbaren Rundfunkprogramme zu detektieren. In diesem Falle liegt im Rundfunkempfänger jederzeit eine Information über die empfangbaren Rundfunkprogramme vor. Alternativ kann diese Information auch mit einer einzigen Empfangsstufe gewonnen werden, wenn diese kurzzeitig das Rundfunkband oder Teile davon scannt.

Mit dem Rundfunkempfangsteil 2 ist ein Decoder 4 verbunden, bei dem es sich hier um einen RDS-Decoder zur Decodierung von RDS-Datensignalen handelt. Derartige RDS-Decoder bzw. Verfahren zur Decodierung von RDS-Signalen sind ebenfalls hinreichend bekannt.

Der Rundfunkempfänger weist weiterhin eine Steuereinheit 5 auf, die mit dem Rundfunksempfangsteil 2, dem Decoder 4 und einer Bedieneinheit 6 sowie einem Display 7 verbunden ist. Weiterhin ist die Steuereinheit 5 mit einem Speicherelement 8 verbunden, wobei das Speicherelement 8 auch integraler Bestandteil der Steuereinheit 5 sein kann. Das Speicherelement 8 kann als ein einziges Speicherelement oder auch als mehrere physikalisch getrennte Speicherelemente ausgebildet sein.

In dem Speicherelement 8 ist eine Vielzahl von Kennungen dauerhaft abgespeichert. Weiterhin sind in dem Speicherelement 8 graphische Elemente sowie eine Zuordnung zwischen den Kennungen und den graphischen Elementen abgespeichert.

Der Rundfunkempfänger ist dazu ausgelegt, mittels des Decoders 4 und/oder der Steuereinheit 5 aus den empfangenen Daten eine Kennung zu extrahieren. Mittels der Steuereinheit 5 wird die extrahierte Kennung mit der Vielzahl von in dem Speicherelement abgespeicherten Kennungen verglichen und bei Übereinstimmung der extrahierten Kennung mit einer der im Speicherelement 8 abgespeicherten Kennungen wird das dieser abgespeicherten Kennung zugeordnete graphische Element ausgewählt und auf dem graphikfähigen Display 7 zur Anzeige gebracht.

Fig. 2 zeigt eine Ausgestaltung, bei der der Rundfunkempfänger Teil eines Kraftfahrzeugmultimediasystems ist. Das Multimediasystem weist ein Rundfunkempfangsteil 22 auf, dem von einer Antenne 21 empfangene Signale zugeführt werden. Weitere Komponenten des Multimediasystems sind beispielsweise ein DVD-Spieler 29 und eine Navigationskomponente 30. Die einzelnen Komponenten werden von einer Steuereinheit 25 gesteuert, an die neben dem Rundfunksempfangsteil 22, dem DVD-Spieler 29 und der Navigationseinheit 30 eine oder auch mehrere Bedieneinheiten 26, mehrere Lautsprecher 23 und mehrere Displays 27 angeschlossen sind. Des Weiteren ist die Steuereinheit 25 mit einem oder mehreren Speicherelementen 28 verbunden, die auch Bestandteil der Steuereinheit 25 selbst sein können.

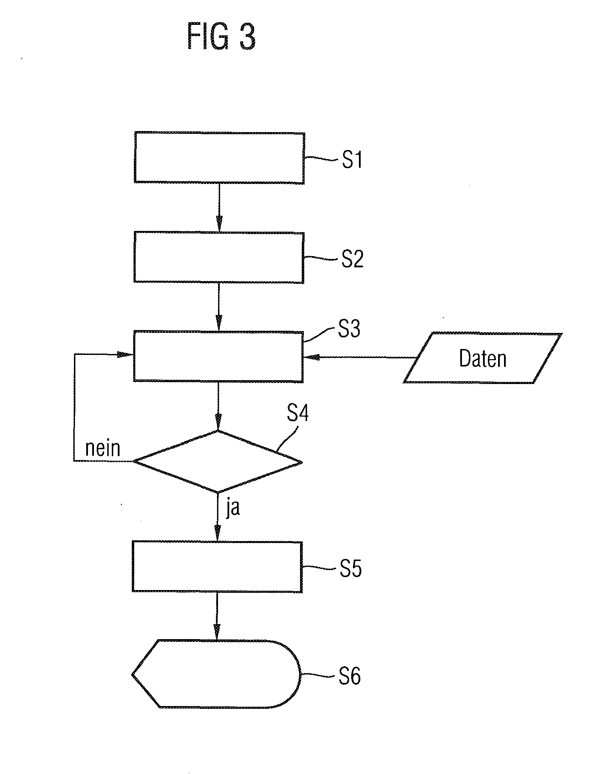

Bei einer Ausführungsform, die eine Navigationskomponente und somit Mittel zur Positionsbestimmung aufweist, kann auch bei Mehrdeutigkeit der empfangenen Kennung eine eindeutige Zuordnung einer abgespeicherten Kennung und des zugehörigen graphischen Elements erreicht werden. Hierzu wird die aktuelle Position des Fahrzeugs und somit auch des Rundfunkempfängers herangezogen. Fährt das Fahrzeug beispielsweise in Süddeutschland und kann der empfangenen Kennung ein nur in Norddeutschland und ein nur in Süddeutschland empfangbares Radioprogramm bzw. empfangbarer Sender zugeordnet werden, so kann aufgrund der Position das nur in Norddeutschland empfangbare Radioprogramm ausgeschlossen werden. Gleiches kann auch durch einen Abgleich der empfangbaren Senderlandschaft erfolgen. Fig. 3 zeigt ein Ablaufdiagramm des erfindungsgemäßen Verfahrens. In Schritt S1 werden Daten, die eine Kennung enthalten, über eine Rundfunkfrequenz empfangen. In Schritt S2 wird die Kennung aus den empfangenen Daten extrahiert. In Schritt S3 wird die extrahierte Kennung mit einer ersten in einem Speicherelement abgespeicherten Kennung verglichen. Wird in Schritt S4 festgestellt, dass der in Schritt S3 durchgeführte Vergleich keine Übereinstimmung ergibt, so wird in Schritt S3 die extrahierte Kennung mit einer weiteren der abgespeicherten Kennungen verglichen. Wird in Schritt S4 dagegen eine Übereinstimmung zwischen der extrahierten Kennung und der abgespeicherten Kennung festgestellt, so wird in Schritt S5 die zu der abgespeicherten Kennung gehörende Graphik ausgewählt und anschließend wird die ausgewählte Graphik in Schritt S6 auf dem graphikfähigen Display dargestellt.

Wird nach Vergleich mit allen abgespeicherten Kennungen keine Übereinstimmung festgestellt, so wird ein für diesen Fall vorgesehenes Logo ausgewählt und auf dem Display dargestellt.

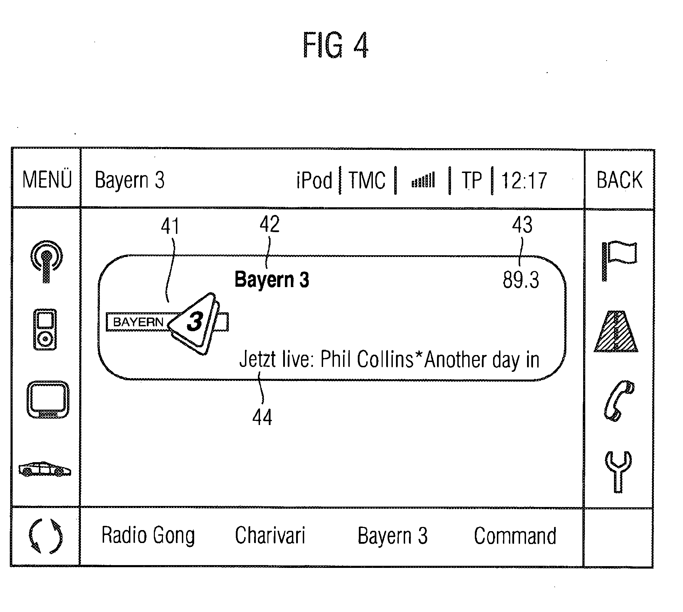

Fig. 4 zeigt eine erste Bildschirmanzeige eines Multimediasystems mit einem erfindungsgemäßen Rundfunkempfänger, der nach dem erfindungsgemäßen Verfahren arbeitet. Im Randbereich des Displays sind unterschiedliche Informationen dargestellt. Im Zentralbereich des Displays wird ein Senderlogo 41, hier für das Radioprogramm von "Bayern 3", dargestellt. Daneben wird im Ausführungsbeispiel eine alphanumerische Anzeige 42 des ausgewählten Radioprogramms "Bayern 3" angezeigt. In einem weiteren Bereich 43 wird zudem die aktuelle Empfangsfrequenz des Radioprogramms angezeigt. In einem Bereich 44 wird schließlich noch eine Information über einen aktuell abgespielten Titel angezeigt. Im gezeigten Ausführungsbeispiel wird die Information über den abgespielten Titel als Text wiedergegeben. Anstelle der Wiedergabe als Text oder auch zusätzlich ist jedoch auch hier eine graphische Darstellung möglich, beispielsweise in Form eines Covers des Liedalbums oder eine Abbildung des Interpreten.

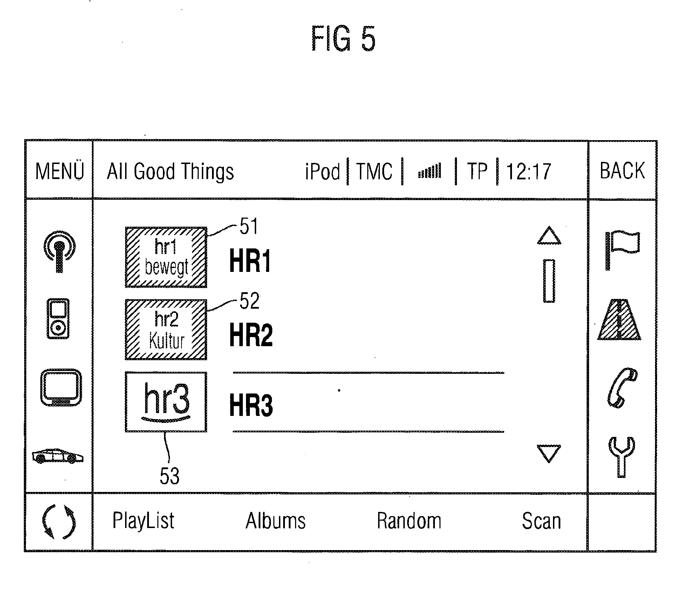

Abbildung 5 zeigt eine zweite Displayansicht, bei der nun Senderlogos 51, 52, 53 mehrerer empfangbarer Programme auf dem Display angezeigt werden. Es besteht hierbei die Möglichkeit, eines der angezeigten Senderlogos auszuwählen und durch Auswahl des entsprechenden Senderlogos den Rundfunkempfänger auf das entsprechende Programm einzustellen. Die Auswahl eines der Programme kann hierbei beispielsweise über einen Dreh-/Drücksteller erfolgen oder durch direktes Antippen des Senderlogos, wenn das Display als Touch-Screen ausgebildet ist.

## Patentansprüche

1. Rundfunkempfänger mit
- einem Rundfunkempfangsteil (2, 22),
- einem Decoder (4) für über eine Rundfunkfrequenz empfangene Daten, die eine Kennung enthalten,
- mindestens einem Speicherelement (8, 28),
- einer Vielzahl von abgespeicherten Kennungen, die in dem mindestens einem Speicherelement (8, 28) abgelegt sind,
- graphischen Elementen, die in dem mindestens einem Speicherelement (8, 28) abgelegt sind, wobei zumindest einigen der abgespeicherten Kennungen jeweils eines der graphischen Elemente zugeordnet ist,
- einem graphikfähigen Display (7, 27),
- Mitteln zum Extrahieren der Kennung aus den empfangenen Daten und zum Vergleich der extrahierten Kennung mit der Vielzahl von in dem Speicherelement (8, 28) abgespeicherten Kennungen und zur Auswahl des einer abgespeicherten Kennung, die mit der extrahierten Kennung übereinstimmt, zugeordneten graphischen Elements,
- Mittel zur Darstellung des ausgewählten graphischen Elements auf dem graphikfähigen Display (7, 27).

2. Rundfunkempfänger nach Anspruch 1, **dadurch g e - kennzeichnet,** dass auf dem Display (7, 27) zusätzlich zu dem graphischen Element eine alphanumerische Anzeige der Kennung darstellbar ist.

3. Rundfunkempfänger nach Anspruch 1 oder 2, **dadurch gekennzeichnet, dass** es sich bei dem Rundfunkempfänger um einen Rundfunkempfänger zum Empfang von analogen Rundfunksendungen handelt.

4. Rundfunkempfänger nach Anspruch 3, **dadurch gekennzeichnet, dass** es sich um Daten des Radiodatensystems handelt.

5. Rundfunkempfänger nach Anspruch 1 oder 2, **dadurch gekennzeichnet, dass** es sich bei dem Rundfunkempfänger um einen Rundfunkempfänger zum Empfang von digitalen Rundfunksendungen handelt.

6. Rundfunkempfänger nach einem der vorhergehenden Ansprüche, **dadurch gekennzeichnet, dass** es sich bei den extrahierten Daten um Kenndaten eines Rundfunkprogramms und bei dem graphischen Element um eine Programmkennung, insbesondere ein Senderlogo, handelt.

7. Rundfunkempfänger nach Anspruch 6, **dadurch gekennzeichnet, dass** auf dem Display Programmkennungen mehrerer empfangbarer Rundfunkprogramme darstellbar sind.

8. Rundfunkempfänger nach einem der vorhergehenden Ansprüche 1 bis 5, **dadurch gekennzeichnet, dass** es sich bei dem graphischen Element um eine Kennung eines Liedtitels oder eines Liederalbums handelt.

9. Rundfunkempfänger nach einem der vorhergehenden Ansprüche, **dadurch gekennzeichnet, dass** der Rundfunkempfänger eine Schnittstelle (9) zum Verbinden des Rundfunkempfängers mit einem mobilen Datenträger (10) und zur Übertragung eines graphischen Elements von dem mobilen Datenträger (10) zu dem Rundfunkempfänger aufweist.

10. Rundfunkempfänger nach einem der vorhergehenden Ansprüche, **dadurch gekennzeichnet, dass** der Rundfunkempfänger als eigenständiges Autoradio ausgebildet ist.

11. Rundfunkempfänger nach einem der vorhergehenden Ansprüche, **dadurch gekennzeichnet, dass** der Rundfunkempfänger Bestandteil eines Multimediasystems, insbesondere eines Kraftfahrzeug-Multimediasystems ist.

12. Rundfunkempfänger nach Anspruch 11, **dadurch g e - kennzeichnet,** dass auf dem Display graphische Elemente zur Kennzeichnung weiterer im Multimediasystem zur Verfügung stehender Liedtitel oder Liedalben anzeigbar sind.

13. Verfahren zum Betreiben eines Rundfunkempfängers mit den Schritten:
- Empfang von Daten, die eine Kennung enthalten, über eine Rundfunkfrequenz,
- Extrahieren der Kennung aus den empfangenen Daten,
- Vergleichen der extrahierten Kennung mit einer Vielzahl von in einem Speicherelement abgespeicherten Kennungen,
- Auswahl eines einer abgespeicherten Kennung, die mit der extrahierten Senderkennung übereinstimmt, zugeordneten graphischen Elements, das in einem Speicherelement abgespeichert ist,
- Darstellen des ausgewählten graphischen Elements auf einem graphikfähigen Display (7, 27).

14. Verfahren nach Anspruch 13, **dadurch gekennzeichnet, dass** auf dem Display (7, 27) zusätzlich zu dem graphischen Element eine alphanumerische Anzeige der Kennung dargestellt wird.

15. Verfahren nach Anspruch 13 oder 14, **dadurch gekennzeichnet, dass** über die Rundfunkfrequenz Rundfunksendungen in einem analogen Sendeverfahren empfangen werden.

16. Verfahren nach Anspruch 15, **dadurch gekennzeichnet, dass** es sich um Daten des Radiodatensystems handelt.

17. Verfahren nach Anspruch 13 oder 14, **dadurch gekennzeichnet, dass** über die Rundfunkfrequenz Rundfunksendungen in einem digitalen Sendeverfahren empfangen werden.

18. Verfahren nach einem der vorhergehenden Ansprüche, **dadurch gekennzeichnet, dass** es sich bei den extrahierten Daten um Kenndaten eines Rundfunkprogramms und bei dem graphischen Element um eine Programmkennung, insbesondere ein Senderlogo, handelt.

19. Verfahren nach Anspruch 16, **dadurch gekennzeichnet, dass** auf dem Display Programmkennungen mehrerer empfangbarer Rundfunkprogramme dargestellt werden.

20. Verfahren nach einem der vorhergehenden Ansprüche 13 bis 17, **dadurch gekennzeichnet, dass** es sich bei dem graphischen Element um eine Kennung eines Liedtitels oder eines Liederalbums handelt.

21. Verfahren nach einem der vorhergehenden Ansprüche, **dadurch gekennzeichnet, dass** das graphische Element von einem mobilen Datenträger (10) in den Rundfunkempfänger übertragen wird.

22. Verfahren nach einem der vorhergehenden Ansprüche, **dadurch gekennzeichnet, dass** es in einem eigenständigen Autoradio oder einem Kraftfahrzeug-Multimediasystem, das ein Autoradio enthält, angewendet wird.

23. Verfahren nach Anspruch 22, **dadurch gekenn- zeichnet,** dass auf dem Display (7, 27) graphische Elemente zur Kennzeichnung weiterer im Multimediasystem zur Verfügung stehender Liedtitel oder Liedalben angezeigt werden.

## Claims

1. Broadcast radio receiver having
- a broadcast radio reception portion (2, 22),
- a decoder (4) for data received using a broadcast radio frequency that contain an identifier,
- at least one memory element (8, 28),
- a multiplicity of stored identifiers that are stored in the at least one memory element (8, 28),
- graphical elements that are stored in the at least one memory element (8, 28), wherein at least some of the stored identifiers each have one of the graphical elements associated with them,
- a graphics-compatible display (7, 27),
- means for extracting the identifier from the received data and for comparing the extracted identifier with the multiplicity of identifiers stored in the memory element (8, 28) and for selecting the graphical element associated with a stored identifier that matches the extracted identifier,
- means for presenting the selected graphical element on the graphics-compatible display (7, 27).

2. Broadcast radio receiver according to Claim 1, **characterized in that** an alphanumeric display of the identifier can be presented on the display (7, 27) in addition to the graphical element.

3. Broadcast radio receiver according to Claim 1 or 2, **characterized in that** the broadcast radio receiver is a broadcast radio receiver for receiving analogue broadcast radio transmissions.

4. Broadcast radio receiver according to Claim 3, **characterized in that** data from the radio data system are involved.

5. Broadcast radio receiver according to Claim 1 or 2, **characterized in that** the broadcast radio receiver is a broadcast radio receiver for receiving digital broadcast radio transmissions.

6. Broadcast radio receiver according to one of the preceding claims, **characterized in that** the extracted data are characteristic data for a broadcast radio programme and the graphical element is a programme identifier, particularly a station logo.

7. Broadcast radio receiver according to Claim 6, **characterized in that** programme identifiers for a plurality of receivable broadcast radio programmes can be presented on the display.

8. Broadcast radio receiver according to one of the preceding Claims 1 to 5, **characterized in that** the graphical element is an identifier for a song title or for an album of songs.

9. Broadcast radio receiver according to one of the preceding claims, **characterized in that** the broadcast radio receiver has an interface (9) for connecting the broadcast radio receiver to a mobile data storage medium (10) and for transmitting a graphical element from the mobile data storage medium (10) to the broadcast radio receiver.

10. Broadcast radio receiver according to one of the preceding claims, **characterized in that** the broadcast radio receiver is in the form of a standalone car radio.

11. Broadcast radio receiver according to one of the preceding claims, **characterized in that** the broadcast radio receiver is part of a multimedia system, particularly a motor vehicle multimedia system.

12. Broadcast radio receiver according to Claim 11, **characterized in that** graphical elements for denoting further song titles or albums of songs that are available in the multimedia system can be displayed on the display.

13. Method for operating a broadcast radio receiver having the steps of:
- reception of data that contain an identifier using a broadcast radio frequency,
- extraction of the identifier from the received data,
- comparison of the extracted identifier with a multiplicity of identifiers stored in a memory element,
- selection of a graphical element - which is stored in a memory element - associated with a stored identifier that matches the extracted station identifier,
- presentation of the selected graphical element on a graphics-compatible display (7, 27).

14. Method according to Claim 13, **characterized in that** an alphanumeric display of the identifier is presented on the display (7, 27) in addition to the graphical element.

15. Method according to Claim 13 or 14, **characterized in that** the broadcast radio frequency is used to receive broadcast radio transmissions in an analogue transmission method.

16. Method according to Claim 15, **characterized in that** data from the radio data system are involved.

17. Method according to Claim 13 or 14, **characterized in that** the broadcast radio frequency is used to receive broadcast radio transmissions in a digital transmission method.

18. Method according to one of the preceding claims, **characterized in that** the extracted data are characteristic data for a broadcast radio programme and the graphical element is a programme identifier, particularly a station logo.

19. Method according to Claim 16, **characterized in that** programme identifiers for a plurality of receivable broadcast radio programmes are presented on the display.

20. Method according to one of the preceding claims 13 to 17, **characterized in that** the graphical element is an identifier for a song title or for an album of songs.

21. Method according to one of the preceding claims, **characterized in that** the graphical element is transmitted from a mobile data storage medium (10) to the broadcast radio receiver.

22. Method according to one of the preceding claims, **characterized in that** it is applied in a standalone car radio or a motor vehicle multimedia system that contains a car radio.

23. Method according to Claim 22, **characterized in that** graphical elements for denoting further song titles or albums of songs that are available in the multimedia system are displayed on the display (7, 27).

## Revendications

1. Récepteur radio comprenant
- une partie (2, 22) de réception radio,
- un décodeur (4) pour des données qui sont reçues sur une fréquence radio et qui contiennent une caractérisation,
- au moins un élément (8, 28) de mémoire,
- une pluralité de caractérisations mémorisées, qui sont mises dans le au moins un élément (8, 28) de mémoire,
- des éléments graphiques qui sont mis dans le au moins un élément (8, 28) de mémoire, respectivement l'un des éléments graphiques étant associé à au moins certaines des caractérisations mémorisées,
- affichage (7, 27) apte à représenter un graphique,
- des moyens d'extraction de la caractérisation des données reçues et de comparaison de la caractérisation extraite à la pluralité de caractérisations mémorisées dans l'élément (8, 28) de mémoire et de sélection de l'élément graphique associé à une caractérisation mémorisée, qui coïncide avec la caractérisation extraite,
- des moyens de représentation de l'élément graphique sélectionné sur l'affichage (7, 27) apte à représenter un graphique.

2. Récepteur radio suivant la revendication 1, **caractérisé en ce qu'**une indication alphanumérique de la caractérisation peut être représentée sur l'affichage (7, 27) en plus de l'élément graphique.

3. Récepteur radio suivant la revendication 1 ou 2, **caractérisé en ce que** le récepteur radio est un récepteur radio de réception d'émissions radio analogiques.

4. Récepteur radio suivant la revendication 3, **caractérisé en ce que** les données sont des données du système radio.

5. Récepteur radio suivant la revendication 1 ou 2, **caractérisé en ce que** le récepteur radio est un récepteur radio de réception d'émissions radio numériques.

6. Récepteur radio suivant l'une des revendications précédentes, **caractérisé en ce que** les données extraites sont des données de caractérisation d'un programme radio et l'élément graphique est une caractérisation d'un programme, notamment un logo d'émetteur.

7. Récepteur radio suivant la revendication 6, **caractérisé en ce que** des caractérisations de programme de plusieurs programmes radio pouvant être reçus peuvent être représentées sur l'affichage.

8. Récepteur radio suivant l'une des revendications précédentes 1 à 5, **caractérisé en ce que** l'élément graphique est une caractérisation d'un titre de chanson ou d'un album de chansons.

9. Récepteur radio suivant l'une des revendications précédentes, **caractérisé en ce que** le récepteur radio a une interface (9) de liaison du récepteur radio à un support (10) de données mobile et de transmission d'un élément graphique du support (10) de données mobile au récepteur radio.

10. Récepteur radio suivant l'une des revendications précédentes, **caractérisé en ce que** le récepteur radio est constitué en autoradio autonome.

11. Récepteur radio suivant l'une des revendications précédentes, **caractérisé en ce que** le récepteur radio fait partie d'un système multimédia, notamment d'un système multimédia de véhicule automobile.

12. Récepteur radio suivant la revendication 11, **caractérisé en ce que** des éléments graphiques de caractérisation d'autres types de chanson ou d'albums de chansons disponibles dans le système multimédia peuvent être affichés sur l'affichage.

13. Procédé pour faire fonctionner un récepteur radio comprenant les stades :
- de réception sur une fréquence radio de données qui contiennent une caractérisation,
- d'extraction de la caractérisation des données reçues,
- de comparaison de la caractérisation extraite à une pluralité de caractérisations mémorisées dans un élément de mémoire,
- de sélection d'un élément graphique associé à une caractérisation mémorisée, qui coïncide avec une caractérisation d'émetteur extraite, l'élément étant mémorisé dans un élément de mémoire,
- de représentation de l'élément graphique sélectionné sur un affichage (7, 27) apte à représenter un graphique.

14. Procédé suivant la revendication 13, **caractérisé en ce que** l'on affiche sur l'affichage (7, 27) un affichage alphanumérique de la caractérisation en plus de l'élément graphique.

15. Procédé suivant la revendication 13 ou 14, **caractérisé en ce que** l'on reçoit sur la fréquence radio des émissions radio dans un procédé d'émission analogique.

16. Procédé suivant la revendication 15, **caractérisé en ce que** les données sont des données du système radio.

17. Procédé suivant la revendication 13 ou 14, **caractérisé en ce que** l'on reçoit sur la fréquence radio des émissions radio dans un procédé d'émission numérique.

18. Procédé suivant l'une des revendications précédentes, **caractérisé en ce que** les données sont des données de caractérisation d'un programme radio et l'élément graphique est une caractérisation de programme, notamment un logo d'émetteur.

19. Procédé suivant la revendication 16, **caractérisé en ce que** l'on représente sur l'affichage des caractérisations de programme de plusieurs programmes radio pouvant être reçus.

20. Procédé suivant l'une des revendications 13 à 17, **caractérisé en ce que** l'élément graphique est une caractérisation d'un titre de chanson ou d'un album de chansons.

21. Procédé suivant l'une des revendications précédentes, **caractérisé en ce qu'**on transmet l'élément graphique d'un support (10) de données mobile au récepteur radio.

22. Procédé suivant l'une des revendications précédentes, **caractérisé en ce qu'**il est utilisé dans une autoradio autonome ou dans un système multimédia de véhicule automobile qui contient une autoradio.

23. Procédé suivant la revendication 22, **caractérisé en ce que** l'on affiche sur l'affichage (7, 27) des éléments graphiques de caractérisation d'autres titres de chanson ou d'album de chansons disponibles dans le système multimédia.
